(19) Europäisches Patentamt
European Patent Office
Office européen des brevets

(11) **EP 0 869 369 B1**

(12) **EUROPÄISCHE PATENTSCHRIFT**

(45) Veröffentlichungstag und Bekanntmachung des Hinweises auf die Patenterteilung:
**14.12.2005 Patentblatt 2005/50**

(51) Int Cl.$^7$: **G01R 15/16**

(21) Anmeldenummer: **98810234.9**

(22) Anmeldetag: **19.03.1998**

(54) **Kapazitiver Spannungswandler für eine metallgekapselte, gasisolierte Hochspannungsanlage**

Capacitive voltage transducer for a metal-encapsulated gas-insulated high voltage installation

Capteur de tension capacitif pour une installation blindée à haute tension à isolation de gaz

(84) Benannte Vertragsstaaten:
**CH DE FR GB IT LI**

(30) Priorität: **04.04.1997 DE 19713916**

(43) Veröffentlichungstag der Anmeldung:
**07.10.1998 Patentblatt 1998/41**

(73) Patentinhaber: **ABB Schweiz AG**
**5400 Baden (CH)**

(72) Erfinder: **Kaczkowski, Andrzej, Dr.**
**5303 Würenlingen (CH)**

(74) Vertreter: **ABB Patent Attorneys**
**c/o ABB Schweiz AG**
**Brown Boveri Strasse 6**
**5400 Baden (CH)**

(56) Entgegenhaltungen:
**US-A- 3 932 810          US-A- 4 240 031**
**US-A- 5 432 438**

- **PATENT ABSTRACTS OF JAPAN vol. 095, no. 009, 31. Oktober 1995 & JP 07 146313 A (MITSUBISHI ELECTRIC CORP), 6. Juni 1995**
- **PATENT ABSTRACTS OF JAPAN vol. 095, no. 009, 31. Oktober 1995 & JP 07 140178 A (SUMITOMO ELECTRIC IND LTD;OTHERS: 01), 2. Juni 1995**

**Beschreibung**

### TECHNISCHES GEBIET

Bei der Erfindung wird ausgegangen von einem kapazitiven Spannungswandler für eine metallgekapselte, gasisolierte Hochspannungsanlage nach dem Oberbegriff von Patentanspruch 1. Ein solcher Spannungswandler enthält einen Zylinderkondensator mit zwei koaxial angeordneten, elektrisch leitenden Zylindern, von denen ein innenliegend angeordneter Zylinder sich auf Hochspannungspotential befindet und ein aussenliegend angeordneter Zylinder elektrisch isoliert in die Metallkapselung eingesetzt ist. Ein solcher Spannungsteiler lässt sich platzsparend in der Metallkapselung unterbringen und kann in einfacher Weise mit einem Stromwandler kombiniert werden.

### STAND DER TECHNIK

Die Erfindung nimmt dabei Bezug auf einen Stand der Technik, wie er sich beispielsweise aus dem europäischen Patent EP 0 522 303 B2 (=U. S. Pat. No. 5,432,428) ergibt. Ein in diesem Stand der Technik veröffentlichter kombinierter Strom- und Spannungswandler für eine metallgekapselte, gasisolierte Hochspannungsanlage weist einen rohrförmig ausgebildeten Metallkapselungsabschnitt auf, einen entlang der Rohrachse geführten Stromleiter und eine isoliert in die Metallkapselung eingesetzte hohlzylinderförmige Messelektrode, welche den vorzugsweise Phasenstrom führenden Stromleiter konzentrisch umgibt. Die Messelektrode bildet mit dem Stromleiter einen zylinderförmigen Kondensator, welcher das vom Stromleiter ausgehende und der anliegenden Hochspannung entsprechende elektrische Feld auskoppelt und als Oberspannungskondensator eines kapazitiven Spannungsteilers wirkt.

Je nach Messaufgabe ist es erforderlich, dass die von diesem Apparat umgewandelten Spannungswerte eine mehr oder weniger grosse Genauigkeit aufweisen. Der die Genauigkeit der umgewandelten Spannungswerte beeinflussende Übertragungsfaktor hängt von der Temperatur des als Spannungssensor wirkenden Zylinderkondensators sowie von der Dichte des in der Anlage befindlichen Isoliergases ab. Die Gasdichte und die Temperatur der als Aussenzylinder wirkenden Messelektrode des Zylinderkondensators können mit geringem Aufwand gemessen und bei der Korrektur der Übertragungsgenauigkeit in einfacher Weise berücksichtigt werden. Hingegen ist es problematisch, die ebenfalls in die Übertragungsgenauigkeit eingehende Temperatur des auf Hochspannungspotential befindlichen und als Innenzylinder des Zylinderkondensators wirkenden Stromleiters zu messen.

In dem U. S. Pat. No. 3,646,412 wird ein gasgefüllter Zylinderkondensator offenbart, der eine physikalische Temperaturkompensation aufweist. Für diesen Zweck werden das Verhältnis von Innenradius des Aussenzylinders zu Aussenradius des Innenzylinders bei einer Referenztemperatur gleich der Eulerschen Zahl e gewählt und dann der thermische Ausdehnungskoeffizient des Innenzylinders und der Gasdruck so aufeinander abgestimmt, dass der Kapazitätswert des Zylinderkondensators weitgehend temperaturunabhängig ist.

In dem japanischen Patent Abstract JP 07 146313 A wird ein gasgefüllter Zylinderkondensator offenbart, bei dem die Durchmesser des inneren Stromleiters und der Messelektrode sowie deren lineare thermische Wärmeausdehnungskoeffizienten so gewählt sind, dass der Kapazitätswert bei Temperaturänderungen im wesentlichen konstant bleibt.

In dem U. S. Pat. No. 3,932,810 wird ein temperaturkompensierter Spannungssensor mit einem optional integrierten Stromsensor offenbart. Der Spannungssensor umfasst einen Spannungsteiler mit einem temperaturabhängigen Hochspannungskondensator und einem temperaturunabhängigen Niederspannungskondensator sowie einen Hilfskondensator, der die gleiche Temperaturabhängigkeit wie der Hochspannungskondensator aufweist und dessen Signal subtrahiert wird, um die Temperaturabhängigkeit im Spannungsteilersignal zu eliminieren. Im zitierten Stand der Technik wird das Stromsensorsignal nicht zur Korrektur des Spannungsteilersignals herangezogen.

### KURZE DARSTELLUNG DER ERFINDUNG

Der Erfindung, wie sie in Patentanspruch 1 angegeben ist, liegt die Aufgabe zugrunde, einen kapazitiven Spannungswandler der eingangs genannten Art für eine metallgekapselte gasisolierte Hochspannungsanlagen anzugeben, welcher sich durch eine hohe Übertragungsgenauigkeit und eine verringerte Temperaturabhängigkeit im Spannungswandlersignal auszeichnet.

Der kapazitive Spannungswandler nach der Erfindung zeichnet sich dadurch aus, dass seine Übertragungsgenauigkeit gegenüber einem vergleichbaren Spannungswandler nach dem Stand der Technik mit einfachen Mittel und ohne zusätzlichen Platzbedarf erheblich verbessert ist.

Erfindungsgemäss werden die vorgenannten vorteilhaften Wirkungen durch eine den Wert des im Stromleiter geführten Stroms erfassende Vorrichtung erreicht. Diese Vorrichtung korrigiert periodisch die umgewandelten Spannungswerte. Einen hierzu erforderlichen Korrekturfaktor bestimmt die Korrekturvorrichtung dadurch, indem sie die Änderung der Kapazität des Zylinderkondensators in Abhängigkeit von einer durch den im Stromleiter geführten Strom hervorgerufenen Temperaturänderung ermittelt. Hierzu werden ein Stromwandler sowie ein Rechner benötigt, welcher aus in Vorversuchen ermittelten anlagespezifischen Parametern und den umgewandelten Stromwerten mit Hilfe eines Rechenprogramms den Korrekturfaktor für die umgewandelten Spannungswerte bestimmt. Von besonderem Vorteil ist diese Ausführungsform des Spannungswandlers nach der Erfindung, wenn der Spannungswandler mit einem Stromwandler kombiniert ist, da dann lediglich nur noch ein üblicherweise sowieso bereits vorhandener Rechner benötigt wird.

In einer Ausführungsform des Spannungswandlers werden diese vorteilhaften Wirkungen durch Wahl eines geeignet ausgebildeten Innenzylinders des als Spannungssensor wirkenden Zylinderkondensators weiter verbessert. Der Innenzylinder enthält ein Mantelrohr aus einem Werkstoff, welches gegenüber dem üblichen Werkstoff für Stromleiter, wie etwa Kupfer oder Aluminium, einen wesentlich geringeren linearen Wärmeausdehnungskoeffizienten aufweist. Das Mantelrohr kann den Stromleiter konzentrisch umgeben und befindet sich auf dem gleichen Potential wie der Stromleiter. Alternativ kann das Mantelrohr auch den Stromleiter bilden. In jedem Fall verändert das vom Betriebsstrom der Anlage erwärmte und als Innenzylinder des Zylinderkondensators wirkende Mantelrohr die in den Übertragungsfaktor eingehende Kapazität des Zylinderkondensators nicht so stark wie ein üblicherweise aus Kupfer oder Aluminium bestehender und als Innenzylinder des Hochspannungskondensators wirkender Stromleiter. Daher weichen die übertragenen Spannungswerte auch bei Betriebsströmen unterschiedlicher Grösse wesentlich geringer voneinander ab als beim Spannungswandler nach dem Stand der Technik.

Wird also die vorstehend beschriebene Korrekturvorrichtung in den das Mantelrohr aus einem Werkstoff mit einem geringen linearen Wärmeausdehnungskoeffizienten enthaltenden kapazitiven Spannungswandler nach der Erfindung eingebaut, so kann dessen Übertragungsfaktor beträchtlich verbessert werden.

Bevorzugte Ausführungsbeispiele der Erfindung und die damit erzielbaren weiteren Vorteile werden nachfolgend anhand von Zeichnungen näher erläutert.

## KURZE BESCHREIBUNG DER ZEICHNUNGEN

In den Zeichnung sind Ausführungsbeispiele der Erfindung schematisch dargestellt, und zwar zeigt:

Fig.1    eine Aufsicht auf einen zentral geführten Schnitt durch ein Teil einer metallgekapselten, gasisolierten Hochspannungsschaltanlage mit Sensoren von kapazitiven Spannungswandlern nach der Erfindung,

Fig.2    eine Vergrösserung eines in Fig.1 durch gestrichelte Umrandung markierten Teils einer Ausführungsform des kapazitiven Spannungswandlers nach der Erfindung,

Fig.3    eine Vergrösserung eines in Fig.1 durch gestrichelte Umrandung markierten Teils einer Ausführungsform des kapazitiven Spannungswandlers nach der Erfindung,

Fig.4    ein Blockschaltbild einer Signalverarbeitungsvorrichtung des kapazitiven Spannungswandlers gemäss Fig.2, und

Fig.5    ein zum Teil als Ersatzschaltbild dargestelltes Schaltschema der Ausführungsformen des Spannungswandlers gemäss den Figuren 2 bis 3.

## WEGE ZUR AUSFÜHRUNG DER ERFINDUNG

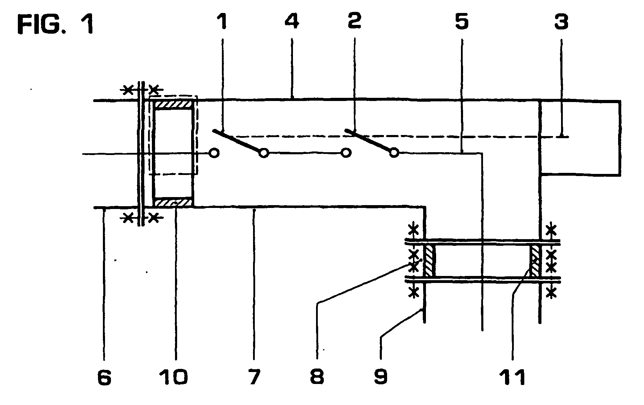

In allen Figuren bezeichnen gleiche Bezugszeichen auch gleichwirkende Teile. In Fig.1 ist ein einen Leistungsschalter mit Schaltstellen 1, 2 und einem Antrieb 3 enthaltender Teil einer metallgekapselten, gasisolierten Hochspannungsschaltanlage dargestellt. Hierbei ist die auf Erdpotential befindliche und mit dem Bezugszeichen 4 bezeichnete rohrförmige Metallkapselung mit einem Isoliergas, wie insbesondere $SF_6$, von einigen bar Druck gefüllt. Im Inneren der Metallkapselung 4 ist ein längs deren Rohrachse erstreckter Stromleiter 5 angeordnet. Dieser Stromleiter ist auf nicht dargestellten, zwischen Kapselungsabschnitten 6, 7 bzw. 7, 8 bzw. 8, 9 eingeflanschten und vorzugsweise eine Isoliergasabschottung bewirkenden Isolatoren abgestützt. Im Inneren der Metallkapselung 4 sind Sensoren 10, 11 vorgesehen. Diese Sensoren umgeben den Stromleiter 5 konzentrisch und weisen mit den sie haltenden Teilen der Metallkapselung 4, d.h. einem Teil des Kapselungsabschnittes 7 bzw. dem Kapselungsabschnitt 8, gleiche Achse auf. Enthält die Metallkapselung 4 mehr als einen Stromleiter, so umgeben die Sensoren die zugeordneten Stromleiter zwar konzentrisch, weisen dann jedoch nicht die gleiche Achse auf wie die Metalikapselung.

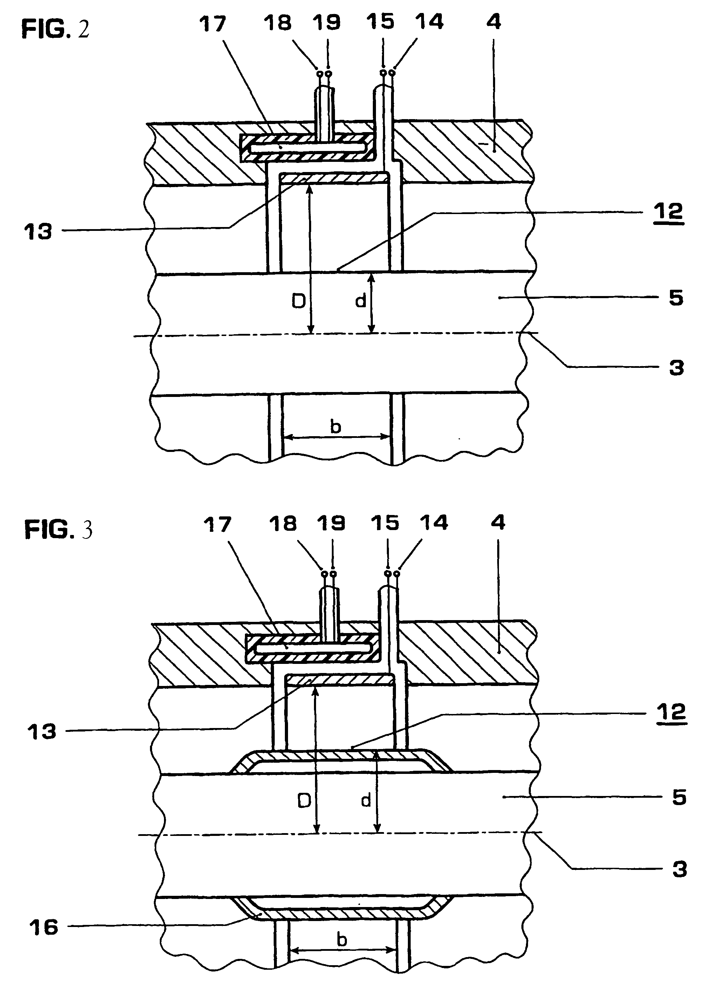

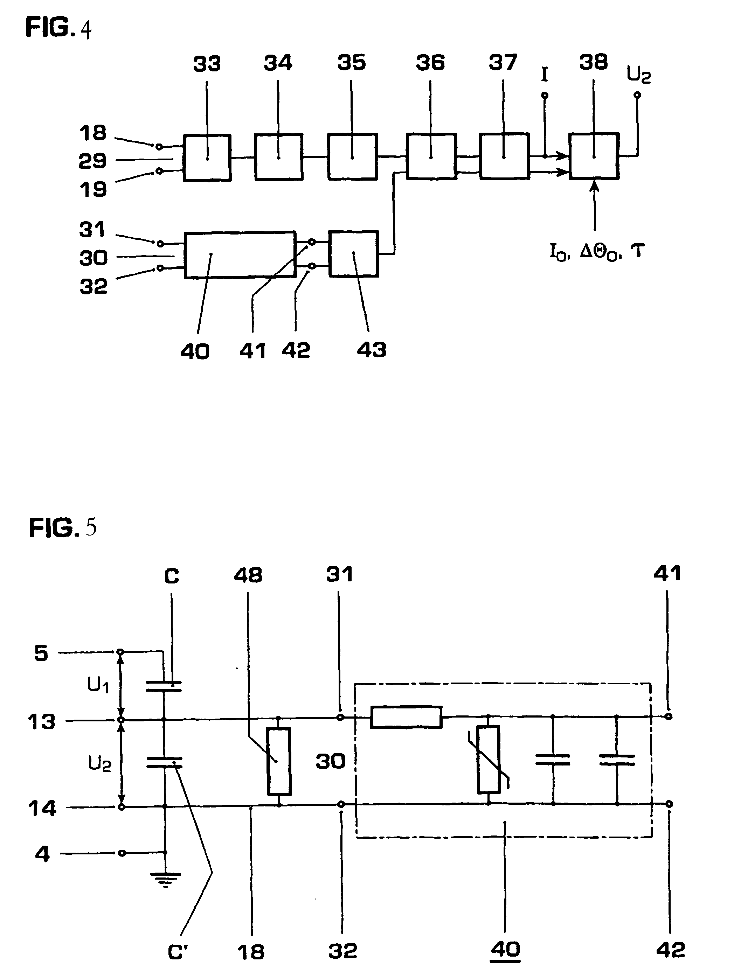

In den Figuren 2 bis 3 ist der in Fig.1 gestrichelt umrandet markierte Bereich von zwei verschiedenen Ausführungsformen des Sensors 10 vergrössert dargestellt. In allen Ausführungsformen ist der Sensor 10 Teil des Spannungsteilers eines kapazitiven Spannungswandlers. Der Spannungswandler weist einen als Spannungssensor dienenden Zylinderkondensator auf mit zwei koaxial angeordneten Zylindern aus elektrisch leitendem Material. Ein innenliegend angeordneter Zylinder 12 befindet sich auf Hochspannungspotential, während ein aussenliegend angeordneter Zylinder 13 elektrisch isoliert in eine in die Innenfläche der Metallkapselung 4 eingelassene Ringnut eingesetzt ist. Der Aussenzylinder 13 besteht aus Aluminium oder Kupfer und weist einen inneren Durchmesser D und eine axiale Länge b auf. Der Aussenzylinder 13 ist mit dem Innenleiter 15 eines eine Abschirmung 14 aufweisenden abgeschirmten Kabels verbunden, welches in gasdichter Weise durch die Metallkapselung 4 hindurch an eine in den Figuren 3 bis 4 nicht dargestellte Signalverarbeitungsvorrichtung des Spannungswandlers geführt ist. Der Innenzylinder 12 besteht bei den Ausführungsformen gemäss den Figuren 3 und 4 aus dem Stromleiter 5 und einem den Stromleiter konzentrisch umgebenden Mantelrohr 16, welches sich auf dem gleichen Potential wie der Stromleiter 5 befindet und welches in axialer Richtung über die beiden Enden des Aussenzylinders 13 hervorragt.

Der Werkstoff des Mantelrohrs 16 weist einen kleineren linearen Wärmeausdehnungskoeffizienten auf als das üblicherweise als Werkstoff für den Stromleiter verwendete Kupfer oder Aluminium und sollte zudem nichtferromagnetisch sein, so dass beispielsweise Invarstahl ausgeschlossen ist. Mit Vorteil ist der lineare Wärmeausdehnungskoeffizient des Werkstoffs des Mantelrohrs kleiner $10 \cdot 10^{-6}$ $K^{-1}$. Als geeigneter Werkstoff für das Mantelrohr kommt vor allem eine Molybdän und/oder Wolfram enthaltende Kupferlegierung in Frage. Bei der Ausführungsform gemäss Fig. 2 ist das Mantelrohr in den Stromleiter 5 integriert und ist so ausgebildet, dass es den Betriebsstrom führen kann.

Bei den Ausführungsformen gemäss den Figuren 2 und 3 befindet sich in der Kapselung 4 jeweils ein vorzugsweise als Rogowskispule 17 ausgebildeter Stromsensor eines induktiven Stromwandlers. Die Signalanschlüsse 18 und 19 der Rogowskispule sind in einem abgeschirmten Kabel gasdicht durch die Kapselung 4 hindurch nach aussen an die in den Figuren 2 und 3 nicht dargestellte Signalverarbeitungsvorrichtung geführt.

Die Wirkungsweise der Spannungswandler gemäss den Figuren 2 bis 3 ist wie folgt: Der Übertragungsfaktor der Spannungswandler hängt linear von der Kapazität des Zylinderkondensators ab. Die Kapazität C dieses Kondensators ist mit ausreichend guter Genauigkeit durch folgende Formel bestimmt:

$C = \varepsilon_0 \cdot \varepsilon_r \cdot 2 \cdot \pi \cdot b / \ln(D/d)$, wobei
$\varepsilon_r$ = die Dielektrizitätskonstante des Isoliergases bedeutet.

Beim Führen von Betriebsstrom stellt sich zwischen dem Innenzylinder 12 und dem Außenzylinder 13 ein Temperaturunterschied $\Delta\theta$ ein. Dieser Temperaturunterschied bewirkt unterschiedliche Änderungen des Aussendurchmessers d des Innenzylinders 12 und des Innendurchmessers D des Aussenzylinders 13. Dementsprechend wird auch die Kapazität C des Zylinderkondensators verändert. Bestehen Innenzylinder 12 und Aussenzylinder 13 bzw. Stromleiter 5 und Kapselung 4 aus dem gleichen Werkstoff, beispielsweise aus Aluminium, und weist dieser Werkstoff den linearen Wärmeausdehnungskoeffizienten $\alpha$ auf, so bestimmt sich die relative Änderung $\Delta C/C$ der Kapazität wie folgt:

$$\Delta C/C = \alpha \cdot \Delta\theta / \ln(D/d).$$

Bestehen der Innenzylinder 12 bzw. das Mantelrohr 16 und der Aussenzylinder 13 bzw. die den Aussenzylinder haltenden Kapselung 5 aus unterschiedlichen Werkstoffen, beispielsweise das Mantelrohr aus einer ca. 15 bis 25 Gewichtsprozent Wolfram enthaltenden Kupferlegierung mit einem linearen Wärmeausdehnungskoeffizienten $\alpha_I = 10 \cdot 10^{-6}$ $K^{-1}$ und die Kapselung aus Aluminium mit einem linearen Wärmeausdehnungskoeffizienten $\alpha_A = 24 \cdot 10^{-6}$ $K^{-1}$, so errechnet sich die Kapazitätsänderung $\Delta C/C$ wie folgt:

$$\Delta C/C = (\Delta\theta_I \cdot \alpha_I - \Delta\theta_A \cdot \alpha_A) / \ln(D/d),$$

wobei $\Delta\theta_I$ bzw. $\Delta\theta_A$ die Erwärmung des Innenzylinders 12 bzw. des Aussenzylinders 13 gegenüber einer vorgegebenen Kalibriertemperatur bedeuten.

In der nachfolgenden Tabelle ist dargestellt, wie sich dies bei unterschiedlichen geometrischen Abmessungen der Zylinder 12, 13 bzw. unterschiedlicher geometrischer Gestaltung der Anlage auswirkt.

| D/d | 2 | 2,7 | 3,5 |
|---|---|---|---|
| $\Delta C/C$ (Material nur Al) in % | 0,121 | 0,085 | 0,067 |
| $\Delta C/C$ (Material innen Cu80W20, aussen Al) in %; Bereiche durch Temperatur der Kapselung bestimmt | 0,01 - 0,05 | 0,007 - 0,035 | 0,006 - 0,028 |

Aus dieser Tabelle ist ersichtlich, dass mit einem Mantelrohr mit einem linearen Wärmeausdehnungskoeffizienten von ca. $10 \cdot 10^{-6} K^{-1}$ gegenüber einem Stromleiter 5 aus Aluminium eine je nach Kapselungstemperatur bis zu 12-fach geringere Kapazitätsänderung auftritt. Entsprechend weisen die übertragenen Spannungswerte eine grössere Genauigkeit von bis zu 0,1% auf.

Bei den Ausführungsformen gemäss den Figuren 2 und 3 kann mit der Rogowskispule zugleich der im Stromleiter 5 fliessende und für die Erwärmung verantwortliche Strom I erfasst werden. Dieser Strom verursacht die unterschiedliche Erwärmung von Innen- und Aussenzylinder des Zylinderkondensators und ruft die unerwünschte Änderung der Kapazität des Zylinderkondensators hervor. Durch Erfassung dieses Stromes kann die Änderung der Kapazität berechnet und hieraus ein Korrekturfaktor zur Verbesserung der übertragenen Spannungswerte erstellt werden. Dies gilt sowohl für die übertragenen Spannungswerte bei einem kapazitiven Spannungswandler, bei dem der Stromleiter 5 aus einem konventionellen Werkstoff, wie etwa Aluminium oder Kupfer, besteht und den Innenzylinder des Zylinderkondensators bildet (Fig.2) oder bei einem kapazitiven Spannungswandler mit einem den Stromleiter 5 umgebenden Mantelrohr 16 aus einem Werkstoff mit einem geringeren linearen Wärmeausdehnungskoeffizienten als Aluminium oder Kupfer (Fig.3).

Mit der in Fig.4 als Blockschaltbild dargestellten Signalverarbeitungsvorrichtung kann diese Korrekturaufgabe ausgeführt werden. Diese Vorrichtung weist zwei Eingänge 29, 30 auf. Dem Eingang 29 werden von der als Stromsensor wirkenden Rogowskispule 17 über die Signalleitungen 18, 19 der zeitlichen Änderung des Stroms I entsprechende Signale zugeführt. Dem Eingang 30 werden über Signalleitungen 31 und 32 von dem den Zylinderkondensator enthaltenden kapazitiven Spannungsteiler des Spannungswandlers der zeitlichen Änderung der am Stromleiter 5 anliegenden Hochspannung $U_1$ entsprechende Spannungssignale $dU_2(t)/dt$ zugeführt. Aus Fig.5 ist zu erkennen, dass diese Signale durch vom Zylinderkondensator mit seiner Kapazität C und einem Hilfskondensator mit der Kapazität C' gebildeten Spannungsteiler und einen zwischen den Aussenzylinder 13 des Zylinderkondensators und die Abschirmung 14 geschalteten ohmschen Widerstand 48 gebildet werden.

Die als Stromsensor wirkende Rogowskispule 17 liefert der zeitlichen Änderung des im Stromleiter 5 fliessenden Stromes proportionale Signale. Diese Signale wirken über einen Überspannungsschutz 33 und einen bei Betrieb der Anlage mit Wechselspannungen von 50 Hz typischerweise einen Durchlassbereich zwischen 0,05 Hz und 5 kHz aufweisenden Bandpass 34 auf den Eingang eines hinsichtlich seines dynamischen Arbeitsbereiches an den Bandpass 34 angepassten Analog-Digital-Wandlers 35. Die im Analog-Digital-Wandler 35 digitalisierten Signale werden nachfolgend in einer vorzugsweise als digitales IIR- Filter ausgebildeten Integriervorrichtung 36 zu einem dem zu ermittelndem Strom I entsprechenden Signal integriert. Dieses Signal wird dann über einen nachgeschalteten Digital-Analog-Wandler 37 zur weiteren Verarbeitung an eine als Rechner ausgeführte Korrekturvorrichtung 38 weitergeleitet.

Dem Eingang 30 werden der zeitlichen Änderung der am Stromleiter 5 anliegenden Hochspannung proportionale Signale $dU_2(t)/dt$ zugeführt. Diese Signale wirken über ein Schutz- und Filterelement 40 und Signalleitungen 41, 42 auf einen entsprechend dem Analog-Digital-Wandlers 35 ausgebildeten Analog-Digital-Wandler 43. Die im Analog-Digital-Wandler 43 digitalisierten Signale werden nachfolgend in der in Multiplexbetrieb arbeitenden Integriervorrichtung 36 aufbereitet und über den Analog-Digital-Wandler 37 der Korrekturvorrichtung 38 zugeführt.

In die Korrekturvorrichtung 38 sind aus Vorversuchen ermittelte Parameter, wie insbesondere ein vorzugsweise dem Nennstrom entsprechender mittlerer Betriebsstrom $I_o$, eine sich beim mittleren Betriebsstrom zwischen dem Stromleiter und der Metallkapselung einstellende Temperaturdifferenz $\Delta\theta_0$ und die thermische Zeitkonstante $\tau$ der Anlage, welche typischerweise bei 1000 bis 2000 s liegt, sowie ein Rechenprogramm eingespeichert. Dieses Rechenprogramm ermittelt periodisch aus den eingespeicherten Parametern und dem periodisch gemessenen Betriebsstrom I die einer Messperiode $\Delta t$ ($300s \geq \Delta t \geq 100ms$) zugeordnete Temperaturdifferenz $\Delta\theta_{ist}$ zwischen Innen- und Aussenzylinder des Zylinderkondensators. Aus der ermittelten Temperaturdifferenz $\Delta\theta_{ist}$, dem Aussendurchmesser d des Innenzylinders 12, dem Innendurchmesser D des Aussenzylinders 13 und den linearen Wärmeausdehnungskoeffizienten $\alpha_I$ von Innenzylinder und $\alpha_A$ von Kapselung wird ein Faktor K zur Korrektur des in der Messperiode $\Delta t$ umgewandelten Spannungswertes bestimmt. Bei einem für Mantelrohr 16 und Kapselung 4 bzw. Aussenelektrode 13 gleichen linearen Wärmeausdehnungskoeffizienten $\alpha_M$ ist der Korrekturfaktor K wie folgt festgelegt:

$$K = 1 - \Delta\theta_{ist} \cdot \alpha M / \ln(D/d).$$

Der in den Korrekturfaktor eingehende Wert von $\Delta\theta_{ist}$ kann folgendermassen ermittelt werden:

(a) der Betriebsstrom I wird in n (n = 1,2,..., i, i+1,...,n) Messperioden $\Delta t$ gemessen,
(b) aus der Grösse des in der i-ten Messperiode bestimmten Betriebsstroms I wird eine fiktive Temperaturdifferenz $\Delta\theta_{Ziel}$ unter Verwendung der Beziehung $\Delta\theta_{Ziel}[i \cdot \Delta t] = \Delta\theta_0 \cdot (I/I_o)^2$ berechnet, und
(c) aus einer nachfolgend angegebenen Rekursionsformel wird der Wert von $\Delta\theta_{ist}$ in der i+1-ten Messperiode aus den zuvor in der i-ten Messperiode bestimmten Werten von $\Delta\theta_{ist}$ und $\Delta\theta_{Ziel}$ wie folgt berechnet:

$$\Delta\theta_{ist}[(i+1)\cdot\Delta t] = \Delta\theta_{ist}[i\cdot\Delta t]\,(1 - \Delta t/\tau) + \Delta\theta_{Ziel}[i\cdot\Delta t]\cdot\Delta t/\tau.$$

Mit dem Faktor K korrigierte Spannungswerte $U_2$ weisen bei einem einer Temperaturdifferenz von $\Delta\theta = 35°K$ und einem Verhältnis D/d von 2 bzw. 2,7 bzw. 3,5 eine Genauigkeit von besser als 0,018% bzw. 0.013% bzw. 0.010% auf.

Bei einem linearen Wärmeausdehnungskoeffizienten $\alpha_I$ für den Werkstoff des Innenzylinders und $\alpha_A$ für den Werkstoff des Aussenzylinders errechnet sich der Korrekturfaktor wie folgt:

$$K = 1 - (\Delta\theta_1\cdot\alpha_1 - \Delta\theta_A\cdot\alpha_A)\,/\,\ln(D/d),$$

wobei $\Delta\theta_I$ bzw. $\Delta\theta_A$ die Erwärmung des Innenzylinders bzw. des Aussenzylinders gegenüber einer vorgegebenen Kalibriertemperatur bedeuten.

Bezugszeichenliste

| | |
|---|---|
| 1, 2 | Schaltstellen |
| 3 | Antrieb |
| 4 | Metallkapselung |
| 5 | Stromleiter |
| 6, 7, 8, 9 | Kapselungsteile |
| 10, 11 | Sensoren |
| 12 | Innenzylinder |
| 13 | Aussenzylinder |
| 14 | Abschirmung |
| 15 | Signalleitung |
| 16 | Mantelrohr |
| 17 | Rogowskispule |
| 18, 19 | Signalleitungen |
| 29, 30 | Eingänge |
| 31, 32 | Signalleitungen |
| 33 | Überspannungsschutz |
| 34 | Bandpass |
| 35 | Analog- Digital- Wandler |
| 36 | Integriervorrichtung |
| 37 | Digital- Analog- Wandler |
| 38 | Korrekturvorrichtung |
| 40 | Schutz- und Filterelement |
| 41, 42 | Signalleitungen |
| 43 | Analog- Digital- Wandler |
| 48 | ohmscher Widerstand |

**Patentansprüche**

**1.** Kapazitiver Spannungswandler für eine metallgekapselte, gasisolierte Hochspannungsanlage mit einem Zylinderkondensator, welcher in koaxialer Anordnung zwei elektrisch leitende Zylinder (12, 13) aufweist, von denen ein innenliegend angeordneter Zylinder (12) sich auf Hochspannungspotential befindet und einen stromführenden Leiter (5) der Hochspannungsanlage nach aussen begrenzt und ein aussenliegend angeordneter Zylinder (13) elektrisch isoliert in die Metallkapselung (4) eingesetzt ist, **dadurch gekennzeichnet, dass** eine den Wert des im Stromleiter (5) geführten Stroms erfassende Korrektur-Vorrichtung (38) zur Korrektur der umgewandelten Spannungswerte vorgesehen ist, wobei in der Korrektur-Vorrichtung (38) die Änderung der Kapazität des Zylinderkondensators in Abhängigkeit einer Temperaturänderung, die durch den im Stromleiter (5) geführten Strom hervorgerufen wird, ermittelt wird.

**2.** Kapazitiver Spannungswandler nach Anspruch 1, **dadurch gekennzeichnet, dass** der innenliegend angeordnete Zylinder (12) ein von einem Werkstoff mit einem kleineren linearen Wärmeausdehnungskoeffizienten als Kupfer gebildetes Mantelrohr (16) aufweist.

**3.** Kapazitiver Spannungswandler nach Anspruch 2, **dadurch gekennzeichnet, dass** das Mantelrohr (16) den Stromleiter (5) konzentrisch umgibt und sich auf dem gleichen Potential wie der Stromleiter (5) befindet.

**4.** Kapazitiver Spannungswandler nach Anspruch 2, **dadurch gekennzeichnet, dass** das Mantelrohr (16) den Stromleiter (5) bildet.

**5.** Kapazitiver Spannungswandler nach Anspruch 3 oder 4, **dadurch gekennzeichnet, dass** der lineare Wärmeausdehnungskoeffizient des Werkstoffs des Mantelrohrs (16) kleiner als $10 \cdot 10^{-6}$ $K^{-1}$ ist.

**6.** Kapazitiver Spannungswandler nach Anspruch 5, **dadurch gekennzeichnet, dass** der Werkstoff des Mantelrohrs (1 6) von einer Molybdän und/oder Wolfram enthaltenden Kupferlegierung gebildet ist.

**7.** Kapazitiver Spannungswandler nach einem der Ansprüche 1 bis 6, **dadurch gekennzeichnet, dass** in der Korrekturvorrichtung (38) aus Vorversuchen ermittelte Parameter eingespeichert sind, sowie ein Rechenprogramm, welches aus den eingespeicherten Parametern und dem periodisch im Stromleiter (5) gemessenen Betriebsstrom I eine einer Messperiode $\Delta t$ zugeordnete Temperaturdifferenz $\Delta\theta_{ist}$ zwischen dem innenliegend angeordneten Zylinder (12) und dem aussenliegend angeordneten Zylinder (13) des Zylinderkondensators ermittelt und aus der ermittelten Temperaturdifferenz, dem Aussendurchmesser d des innenliegend angeordneten Zylinders (12), dem Innendurchmesser D des aussenliegend angeordneten Zylinders (13) und den linearen Wärmeausdehnungskoeffiziente $\alpha_I$ des innenliegend angeordneten Zylinders (12) und $\alpha_A$ der Metall-Kapselung (4) einen Faktor K zur Korrektur des in der Messperiode $\Delta t$ umgewandelten Spannungswertes bestimmt.

**8.** Kapazitiver Spannungswandler nach Anspruch 7, **dadurch gekennzeichnet, dass** die aus Vorversuchen ermittelten Parameter ein vorzugsweise dem Anlagennennstrom entsprechender mittlerer Betriebsstrom $I_o$, eine sich beim mittleren Betriebsstrom $I_o$ zwischen dem Stromleiter (5) und der Metallkapselung (4) einstellende Temperaturdifferenz $\Delta\theta_o$ und eine thermische Zeitkonstante $\tau$ der Anlage sind.

**9.** Kapazitiver Spannungswandler nach Anspruch 7 oder 8, **dadurch gekennzeichnet, dass** bei einem für das Mantelrohr (16) und die Metall-Kapselung (4) gleichen linearen Wärmeausdehnungskoeffizienten $\alpha_M$ der Korrekturfaktor K wie folgt berechnet wird:

$$K = 1 - \Delta\theta_{ist} \cdot \alpha_M / \ln(D/d).$$

**10.** Kapazitiver Spannungswandler nach einem der Ansprüche 7 bis 9, **dadurch gekennzeichnet, dass** das Rechenprogramm die einer Messperiode $\Delta t$ zugeordnete Temperaturdifferenz $\Delta\theta_{ist}$ wie folgt ermittelt:

(a) der Betriebsstrom I wird in n (n = 1,2,..., i, i+1,...,n) Messperioden $\Delta t$ gemessen,
(b) aus der Grösse des in der i-ten Messperiode bestimmten Betriebsstroms I wird eine fiktive Temperaturdifferenz $\Delta\theta_{Ziel}$ unter Verwendung der Beziehung $\Delta\theta_{ziel}[i \cdot \Delta t] = \Delta\theta_o (I/I_o)^2$ berechnet, und
(c) aus einer nachfolgend angegebenen Rekursionsformel wird der Wert von $\Delta\theta_{ist}$ in der i+1-ten Messperiode aus den zuvor in der i-ten Messperiode bestimmten Werten von $\Delta\theta_{ist}$ und $\Delta\theta_{Ziel}$ wie folgt berechnet:

$$\Delta\theta_{ist}[(i+1) \cdot \Delta t] = \Delta\theta_{ist}[i.\Delta t] (1 - \Delta t/\tau) + \Delta\theta_{Ziel}[i \cdot \Delta t] \cdot \Delta t/\tau, \text{ wobei i = 1, 2, ..., n und } \Delta\theta_{ist}[n \cdot \Delta t] = \Delta\theta_{ist}.$$

**11.** Kapazitiver Spannungswandler nach einem der Ansprüche 7 bis 10, **dadurch gekennzeichnet, dass** die Dauer einer Messperiode $\Delta t$ zwischen 100 ms und 300 s liegt.

**12.** Kapazitiver Spannungswandler nach Anspruch 7, **dadurch gekennzeichnet, dass** bei einem linearen Wärmeausdehnungskoeffizienten $\alpha_I$ für den Werkstoff des innenliegend angeordneten Zylinders (12) und $\alpha_A$ für den Werkstoff des aussenliegend angeordneten Zylinders (13) der Korrekturfaktor K wie folgt berechnet wird:

$$K = 1 - (\Delta\theta_I \cdot \alpha_I - \Delta\theta_A \cdot \alpha_A) / \ln(D/d),$$

wobei $\Delta\theta_I$ bzw. $\Delta\theta_A$ die Erwärmung des innenliegend angeordneten Zylinders (12) bzw. des aussenliegend angeordneten Zylinders (13) gegenüber einer vorgegebenen Kalibriertemperatur ist.

13. Kapazitiver Spannungswandler nach einem der Ansprüche 1 bis 12, **dadurch gekennzeichnet, dass** der Stromleiter (5) Teil eines mit dem Kapazitiven Spannungswandler kombinierten und auf den Eingang der Korrekturvorrichtung (38) wirkenden Stromwandlers ist.

**Claims**

1. Capacitive voltage transformer for a metal-enclosed, gas-filled high-voltage system, having a cylindrical capacitor which has two coaxially arranged, electrically conducting cylinders (12, 13), of which an internally arranged cylinder (12) is at a high voltage potential and outwardly bounds a current-carrying conductor (5) of the high voltage system, and an externally arranged cylinder (13) is inserted in an electrically insulated fashion into the metal enclosure (4), **characterized in that** there is provided, for the purpose of correcting the transformed voltage values, a correcting device (38) which detects the value of the current carried in the conductor (5), the change in the capacitance of the cylindrical capacitor being determined in the correcting device (38) as a function of a change in temperature which is caused by the current carried in the conductor (5).

2. Capacitive voltage transformer according to Claim 1, **characterized in that** the internally arranged cylinder (12) has an enclosing tube (16) formed from a material which has a lower coefficient of linear thermal expansion than copper.

3. Capacitive voltage transformer according to Claim 2, **characterized in that** the enclosing tube (16) concentrically surrounds the conductor (5) and is at the same potential as the conductor (5).

4. Capacitive voltage transformer according to Claim 2, **characterized in that** the enclosing tube (16) forms the conductor (5).

5. Capacitive voltage transformer according to Claim 3 or 4, **characterized in that** the coefficient of linear thermal expansion of the material of the enclosing tube (16) is lower than $10 \times 10^{-6} K^{-1}$.

6. Capacitive voltage transformer according to Claim 5, **characterized in that** the material of the enclosing tube (16) is formed from a copper alloy containing molybdenum and/or tungsten.

7. Capacitive voltage transformer according to one of Claims 1 to 6, **characterized in that** parameters determined from preliminary tests are stored in the correcting device (38), as is a computer program which determines from the stored parameters and the operating current I periodically measured in the conductor (5) a temperature difference $\Delta\theta_{act}$ assigned to a measuring period $\Delta t$ between the internally arranged cylinder (12) and the externally arranged cylinder (13) of the cylindrical capacitor, and determines from the temperature difference determined, the outside diameter d of the internally arranged cylinder (12), the inside diameter D of the externally arranged cylinder (13) and the coefficients of linear thermal expansion $\alpha_I$ of the internally arranged cylinder (12) and $\alpha_A$ of the metal enclosure (4) a factor K for correcting the voltage value transformed in the measuring period $\Delta t$.

8. Capacitive voltage transformer according to Claim 7, **characterized in that** the parameters determined from preliminary tests are a mean operating current $I_0$ preferably corresponding to the nominal system current, a temperature difference $\Delta\theta_0$ set up between the conductor (5) and the metal enclosure (4) in the case of the mean operating current $I_0$, and a thermal time constant $\tau$ of the system.

9. Capacitive voltage transformer according to Claim 7 or 8, **characterized in that** in the case of a coefficient of linear thermal expansion $\alpha_M$ identical for the enclosing tube (16) and metal enclosure (4), the correction factor K is calculated as follows: $K = 1 - \Delta\theta_{act} \times \alpha_M / \ln(D/d)$.

10. Capacitive voltage transformer according to Claims 7 to 9, **characterized in that** the computer program determines the temperature difference $\Delta\theta_{act}$ assigned to a measuring period $\Delta t$ as follows:

(a) the operating current I is measured in n(n=1,2,..., i, i+1, ..., n) measuring periods $\Delta t$,

(b) a fictitious temperature difference $\Delta\theta_{target}$ is calculated from the magnitude of the operating current I determined in the ith measuring period, using the relationship $\Delta\theta_{target}[i\times\Delta t] = \Delta\theta\times(I/I_0)^2$, and

(c) the value of $\Delta\theta_{act}$ in the (i+1)th measuring period is calculated, using a recursion formula specified below, from the values of $\Delta\theta_{act}$ and $\Delta\theta_{target}$ previously determined in the ith measuring period, as follows:

$$\Delta\theta_{act}\ [(i+1)\times\Delta t] = \Delta\theta_{act}\ [i\times\Delta t]\ (1-\Delta t/\tau) + \Delta\theta_{target}\ [i\times\Delta t]\times\Delta t/\tau,$$

it being the case that i=1,2,...,n and $\Delta\theta_{act}\ [n\times\Delta t] = \Delta\theta_{act}$.

**11.** Capacitive voltage transformer according to one of Claims 7 to 10, **characterized in that** the duration of a measuring period $\Delta t$ is between 100 ms and 300 s.

**12.** Capacitive voltage transformer according to Claim 7, **characterized in that** in the case of a coefficient of linear thermal expansion $\alpha_I$ for the material of the internally arranged cylinder (12) and $\alpha_A$ for the material of the externally arranged cylinder (13), the correction factor K is calculated as follows:

$$K=1- (\Delta\theta_I\times\alpha_I-\Delta\theta_A\times\alpha_A)/\ln(D/d),$$

it being the case that $\Delta\theta_I$ and $\Delta\theta_A$ are the heating of the internally arranged cylinder (12) or of the externally arranged cylinder (13) with respect to a prescribed calibration temperature.

**13.** Capacitive voltage transformer according to one of Claims 1 to 12, **characterized in that** the conductor (5) is part of a current transformer which is combined with the capacitive voltage transformer and acts on the input of the correcting device (38).

**Revendications**

**1.** Convertisseur capacitif de tension pour installation à haute tension encapsulée dans le métal et isolée par du gaz, qui présente un condensateur à cylindres qui comprend deux cylindres (12, 13) électriquement conducteurs agencés coaxialement, dont le cylindre (12) situé à intérieur est placé à un potentiel élevé et limite vers l'extérieur un conducteur électrique (5) de l'installation à haute tension et le cylindre (13) situé à l'extérieur est installé de manière électriquement isolée dans l'encapsulation métallique (4), **caractérisé en ce qu'**un dispositif (38) de correction des valeurs de tension converties, qui saisit la valeur du courant qui passe dans le conducteur électrique (5) est prévu, le dispositif (38) détectant la modification de la capacité du condensateur à cylindres en fonction du changement de température provoqué par le courant qui traverse le conducteur électrique (5).

**2.** Convertisseur dé tension selon la revendication 1, **caractérisé en ce que** le cylindre (12) situé à l'intérieur présente un tube d'enveloppe (16) en un matériau dont le coefficient de dilatation thermique linéaire est inférieur à celui du cuivre.

**3.** Convertisseur de tension selon la revendication 2, **caractérisé en ce que** le tube d'enveloppe (16) entoure concentriquement le conducteur électrique (5) et est placé au même potentiel que le conducteur électrique (5).

**4.** Convertisseur de tension selon la revendication 2, **caractérisé en ce que** le tube d'enveloppe (16) forme le conducteur électrique (5).

**5.** Convertisseur de tension selon les revendications 3 ou 4, **caractérisé en ce que** le coefficient de dilatation thermique linéaire du matériau du tube d'enveloppe (16) est inférieur à $10 \cdot 10^{-6}\ K^{-1}$.

**6.** Convertisseur de tension selon la revendication 5, **caractérisé en ce que** le matériau du tube d'enveloppe (16) est formé d'un alliage de cuivre qui contient du molybdène et/ou du tungstène.

**7.** Convertisseur capacitif de tension selon l'une des revendications 1 à 6, **caractérisé en ce que** le dispositif de correction (38) conserve en mémoire des paramètres déterminés à partir de tests préalables et un programme de calcul qui, à partir des paramètres conservés en mémoire et du courant de fonctionnement I périodiquement mesuré dans le conducteur électrique (5), détermine entre le cylindre intérieur (12) et le cylindre extérieur (13) du condensateur à cylindres une différence de température $\Delta\theta_{effectif}$ associée à une période de mesure $\Delta t$ et, à partir de la différence de température déterminée, du diamètre extérieur d du cylindre intérieur (12), du diamètre intérieur D du cylindre extérieur (13) et des coefficients $\alpha_I$ et $\alpha_A$ de dilatation thermique linéaire respectifs du cylindre intérieur (12) et du blindage métallique (4), détermine un facteur K de correction de la valeur de la tension convertie pendant la période $\Delta t$

8.  Convertisseur capacitif de tension selon la revendication 7, **caractérisé en ce que** les paramètres déterminés à partir de tests préalables sont le courant moyen de fonctionnement $I_o$ qui correspond de préférence au courant nominal de l'installation, la différence de température $\Delta\theta_o$ qui s'établit entre le conducteur électrique (5) et le blindage métallique (4) pour le courant moyen de fonctionnement $I_o$ et une constante thermique temporelle $\tau$ de l'installation.

9.  Convertisseur capacitif de tension selon les revendications 7 ou 8, **caractérisé en ce que**, lorsque le tube d'enveloppe (16) et le blindage métallique (4) présentent un même coefficient de dilatation thermique linéaire $\alpha_M$, le facteur de correction K est calculé comme suit :

$$K = 1 - \Delta\theta_{effectif} \cdot \alpha_M / \ln(D/d).$$

10. Convertisseur capacitif de tension selon l'une des revendications 7 à 9, **caractérisé en ce que** le programme de calcul détermine la différente de température $\Delta\theta_{effectif}$ associée à une période de mesure $\Delta t$ en exécutant les étapes qui consistent à :

    (a) mesurer le courant de fonctionnement I au cours de n périodes de mesure $\Delta t$ (n = 1, 2, ..., i, i + 1, ..., n),
    (b) déterminer une différence de température fictive $\Delta\theta_{consigne}$ à partir du niveau du courant de fonctionnement I déterminé lors de l'i$^{ième}$ période de mesure, à l'aide de l'équation:

$$\Delta\theta_{consigne} [i.\Delta t] = \Delta\theta_o \ (I/I_o)^2 \ et$$

    c) calculer comme suit et à l'aide d'une formule de récurrence donnée ci-dessous la valeur de $\Delta\theta_{effectif}$ lors de l'(i + 1)$^{ième}$ période de mesure à partir des valeurs de $\Delta\theta_{effectif}$ et de $\Delta\theta_{consigne}$ déterminées précédemment lors de l'i$^{ième}$ période de mesure:

$$\Delta\theta_{effectif} [(i+1)\cdot\Delta t] = \Delta\theta_{ecffectif} [i \cdot \Delta t] (1\Delta t /\tau) + \Delta\theta_{consigne} [i \cdot \Delta t] \cdot \Delta t/\tau$$

    dans laquelle i = 1, 2, ..., n
    et $\Delta\theta_{effectif} [n \cdot \Delta t] = \Delta\theta_{effectif}$.

11. Convertisseur capacitif de tension selon l'une des revendications 7 à 10, **caractérisé en ce qu'**une période de mesure $\Delta t$ dure entre 100 ms et 300 s.

12. Convertisseur capacitif de tension selon la revendication 7, **caractérisé en ce que**, pour les coefficients de dilatation thermique linéaire $\alpha_I$ et $\alpha_A$ respectifs du matériau du cylindre intérieur (12) et du cylindre extérieur (13), le facteur de correction K est calculé comme suit :

$$K = 1 - (\Delta\theta_I \cdot \alpha_I - \Delta\theta_A \cdot \alpha_A)/\ln (D/d),$$

    où $\Delta\theta_I$ et $\Delta\theta_A$ représentent respectivement l'échauffement du cylindre intérieur (12) et celui du cylindre extérieur (13) par rapport à une température prédéfinie d'étalonnage.

13. Convertisseur capacitif de tension selon l'une des revendications 1 à 12, **caractérisé en ce que** le conducteur électrique (5) fait partie d'un convertisseur de courant qui est combiné au convertisseur capacitif de tension et qui agit sur l'entrée du dispositif de correction (38).

EP 0 869 369 B1

**FIG. 1**

**FIG.** 2

**FIG.** 3

13

**FIG.** 4

**FIG.** 5